# EUROPÄISCHE PATENTSCHRIFT

(11) **EP 1 695 425 B1**
(45) Veröffentlichungstag und Bekanntmachung des Hinweises auf die Patenterteilung: **05.03.2008**
(21) Anmeldenummer: 04802938.3
(22) Anmeldetag: 14.12.2004
(51) Int. Cl.: H02H 1/00, G01R 31/12

(54) **VERFAHREN UND VORRICHTUNG ZUR ERKENNUNG EINER BREITBANDIGEN RAUSCHQUELLE IN EINEMGLEICHSPANNUNGS-VERTEILUNGSNETZ**
METHOD AND DEVICE FOR DETECTING A BROAD-BAND NOISE SOURCE IN A DIRECT VOLTAGE DISTRIBUTION NETWORK
PROCEDE ET DISPOSITIF DE DETECTION D'UNE SOURCE DE BRUIT A BANDE LARGE DANS UN RESEAU DE DISTRIBUTION A TENSION CONTINUE

(30) Priorität: 17.12.2003 DE 10359532
(43) Veröffentlichungstag der Anmeldung: 30.08.2006
(73) Patentinhaber: Fachhochschule Dortmund, 44139 Dortmund (DE)
(72) Erfinder: KRÜGER, Manfred, 59558 Lippstadt (DE)
(74) Vertreter: Schneider, Uwe
(86) Internationale Anmeldenummer: PCT/DE2004/002735
(87) Internationale Veröffentlichungsnummer: WO 2005/060063

(56) Entgegenhaltungen:
- EP-A- 1 289 091
- US-A- 5 729 145
- US-B1- 6 625 550

## Beschreibung

Die Erfindung betrifft ein Verfahren und eine Vorrichtung gemäß Oberbegriff des Anspruches 1 bzw. des Anspruches 15.

Die Erkennung elektrischer Bogenentladungen bzw. Lichtbögen in elektrischen Verteilungsnetzen ist ein in der Vergangenheit häufig untersuchtes Problem, das in den letzten Jahren zunehmende Bedeutung erlangt hat. Waren in der Vergangenheit derartige elektrische Verteilungsnetze üblicherweise Installationen in Gebäuden oder dergleichen, so tritt zunehmend die Erkennung von Bogenentladungen bzw. Lichtbögen in elektrisch betriebenen oder mit elektrischen Einrichtungen versehenen, mobilen Einheiten wie etwa Fahrzeugen in den Vordergrund. Insbesondere durch die bevorstehende Veränderung der Versorgungsspannung an Fahrzeugen wie etwa auf das 42 Volt Spannungsnetz bei Personenkraftfahrzeugen wird die Erkennung von Bogenentladungen bzw. Lichtbögen in derartigen Verteilungsnetzen von großer Wichtigkeit, da durch die erhöhten Spannungen die Gefahr des Auftretens entsprechender Bogenentladungen bzw. Lichtbögen deutlich zunimmt bzw. entstandene Lichtbögen zumindest zeitweise stationär brennen können.

Elektrische Lichtbögen können Temperaturen hervorrufen, die zum Zünden der im Bereich des Lichtbogens verwendeten und meist üblichen brennbaren Materialien führen können. So können sich beispielsweise Stromkabel durch fehlerhafte Isolierungen oder sonstige Schadstellen aufgrund äußerer Belastungen oder auch der Alterung der Isolierungsmaterialien so verändern, daß Lichtbögen zwischen den isolierten Leitern hervorgerufen werden und damit nach Überschreiten der Zündtemperaturen des isolierten Materials des Kabels ein Kabelbrand hervorgerufen werden kann.

Hierbei unterscheidet man im wesentlichen zwei Arten von Lichtbögen, die elektrischen Verteilungsnetzen gefährlich werden können. Zum einen handelt es sich um kurzzeitige, aber sehr energieintensive Lichtbögen, die beispielsweise an Schaltkontakten, Steckkontakten oder dergleichen Stellen auftreten können und etwa durch Korrosion der Kontakte oder zu hohe Abnutzungen im Kontaktbereich entstehen. Derartige energiereiche Lichtbögen führen aber meist schnell zu einer Überlastung des Verteilungsnetzes, so daß die üblicherweise vorgesehene Sicherung ansprechen und den Lichtbogen durch Abschalten wirksam unterbrechen kann. Problematischer hingegen sind bei geringeren Spannungen auftretende, aber über eine längere Zeit anhaltende Bogenentladungen etwa aufgrund der schon vorstehend genannten Fehler in Isolierungen, Beschädigungen von Kabeln durch Knickstellen oder dergleichen oder auch durch mechanische Belastung oder Vibrationsbelastung auftretende Fehlstellen. Derartige Lichtbögen führen zwar erst nach einer wesentlich längeren Zeit als die hoch-energiereichen Lichtbögen zu einem Versagen, da eine vorgesehene Sicherung häufig nicht anspricht, können jedoch bis dahin wesentlich größere Schäden an dem Verteilungsnetz und eventuell angeschlossenen Verbrauchern hervorrufen. Derartige Kontakt-Bogenentladungen treten üblicherweise in Reihenschaltung mit einer Last auf. Dadurch ist der maximale Strom im Lichtbogen durch den Laststrom des Verbrauchers begrenzt und kann deshalb merklich unterhalb der Ansprechschwelle der zugehörigen Sicherung liegen. Kann aber die Sicherung nicht rechtzeitig ansprechen, so brennt der Lichtbogen unverändert weiter und kann dadurch wesentlich größere Schäden bzw. auch weiterreichende Schäden als ein kurzzeitige hoch-energiereicher Lichtbogen hervorrufen, der relativ schnell zum Auslösen der Sicherung führt.

Insbesondere in Fahrzeugen, die durch ihre Verwendung sehr unterschiedlichen und teilweise sehr extremen Belastungen mechanischer und thermischer Art unterliegen können, können derartige Lichtbögen auftreten, wenn statt der bisher weit verbreiteten 12 Volt-Bordnetze zukünftig Bordnetze mit höheren Versorgungsspannungen wie etwa 42 Volt Spannungen verwendet werden. Durch diese höhere Spannung können sich langdauernd brennende Lichtbögen entwickeln, die etwa durch fehlerhafte Steckkontakte, sich lösende Verbindungen, durchgesteuerte Kabel oder dergleichen entstehen und zu einem teilweisen oder ganzen Versagen der Bordelektronik sowie ebenfalls der sicherheitsrelevanten, elektrisch betriebenen Teile des Kraftfahrzeuges führen können. Daher sind derartige Lichtbögen bei den kommenden 42 Volt Bordnetzen für Kraftfahrzeuge unbedingt zu vermeiden bzw. im Falle eines Auftretens zu erkennen und entsprechende Sicherungsmaßnahmen durchzuführen.

Insbesondere bei der Überwachung von Bordnetzen an Kraftfahrzeugen ist die Sachlage insofern gegenüber fest installierten Verteilungsnetzen problematischer, da in einem Fahrzeug eine Vielzahl von unterschiedlichen Verbrauchern eingebaut sind, die sehr unterschiedliche Störungen in dem Bordnetz hervorrufen können. Aufgrund dieses unterschiedlichen Verhaltens ist die Erkennung von Lichtbögen innerhalb des Bordnetzes schwierig, da eine Vielzahl sich überlagernder und teilweise mit dem Signalverhalten von Lichtbögen identischer oder ähnlicher Signalverläufe durch die verschiedenen Verbraucher, aber auch durch die Art der Erzeugung der elektrischen Energie in dem Fahrzeug in das Bordnetz eingespeist werden.

Es hat sich bei Untersuchungen herausgestellt, daß die meisten der üblicherweise und bei bestimmungsgemäßem Verhalten der Verbraucher in einem Bordnetz auftretenden Signalverläufe zyklisch auftreten bzw. durch Schaltvorgänge geprägt sind und in ihrer Frequenz nur relativ schmalbandige Störungen in das Bordnetz einkoppeln. Daher kann man derartige Signalverläufe aus dem Signalverhalten in dem Verteilungsnetz extrahieren und das sich daraus ergebende restliche Spektrum für die Erkennung von Lichtbögen heranziehen.

Hierzu gibt es eine Reihe von Ansätzen.

Die US-PS 5 223 795 beschreibt eine Schaltung zur Erkennung von Lichtbögen in Wechselspannungs-Verteilnetzen, bei der ein in einem Wechse Ispannungsverlauf durch charakteristische Signalformen erkennbarer Lichtbogen erkannt wird. Der charakteristische Wechselspannungsverlauf ergibt sich durch den Aufbau und das Zusammenbrechen eines Lichtbogens aufgrund der jeweiligen Momentanspannung und sich daraus ergebende zyklische Verläufe mit Lücken im Frequenzverlauf zu jeder Halbperiode des Stromwellenzuges, die als Kriterium für das Vorliegen einer Bogenentladung angesehen werden.

Aus der DE 696 10 420 T2 ist ein Verfahren und eine Vorrichtung zur Überwachung einer Versorgungsspannung in einem Wechselspannungs-Verteilungsnetz bekannt, bei der die Versorgungsspannung auf das Vorhandensein hochfrequenten Rauschens in der Zeit- und in der Frequenzdarstellung überwacht wird, wobei als charakteristische Spannungsverläufe wiederum Lücken im Wechselspannungsverlauf und deren Zuordnungen zu der Versorgungsspannung ausgewertet werden.

Weiterhin sind aus der WO 02/080326 A1 und der CA 2 379 453 A1 Verfahren zur Erkennung eines Lichtbogens in einem Fahrzeug-Gleichspannungs-Verteilungsnetz bekannt, bei denen ein superheterodyner Schaltkreis zur Filterung verwendet wird, indem über eine angelegte Oszillatorfrequenz das Filterverhalten des superheterodynen Schaltkreises über einen Frequenzbereich verändert und das gefilterte Signal einem Komparator zugeführt wird, der über eine Referenzspannung Veränderungen der gefilterten Signalverläufe erkennen und über ein Zeitglied derartige Veränderungen als Lichtbogen innerhalb des Fahrzeug-Gleichspannungs-Verteilungsnetz anzeigen bzw. weitermelden soll. Nachteilig hieran ist der komplizierte Aufbau einer derartigen Vorrichtung und die daraus folgenden Probleme hinsichtlich des Einsatzes im rauhen Fahrzeugbetrieb sowie die Notwendigkeit einer Referenz-Spannungsquelle.

Aus der US-PS 5 729 145 ist ein für die Wechselstromtechnik für Hausinstallationen gedachtes System zur Erfassung von Bogenentladungen bekannt, bei dem mittels eines Filters in Form einer Schwingspule ein Frequenzbereich kontinuierlich auf Störungen bestimmter Charakteristik anhand von Nulldurchgängen abgesucht wird, die als Indiz für das Vorliegen einer Bogenentladung dienen können.

Aufgabe der vorliegenden Erfindung ist es daher, ein Verfahren und eine Vorrichtung zur Erkennung eines Lichtbogens in Gleichspannungs-Verteilungsnetzen insbesondere von Kraftfahrzeugen vorzuschlagen, bei dem mit geringem gerätetechnischen Aufwand und unter den in Fahrzeuge auftretenden Umgebungsverhältnissen eine sichere Erfassung in dem Gleichspannungs-Verteilungsnetz auftretender Bogenentladungen bzw. Lichtbögen gewährleistet ist.

Die Lösung der erfindungsgemäßen Aufgabe ergibt sich hinsichtlich des Verfahrens aus den kennzeichnenden Merkmalen des Anspruches 1 und hinsichtlich der Vorrichtung aus den kennzeichnenden Merkmalen des Anspruches 15 jeweils in Zusammenwirken mit den Merkmalen des zugehörigen Oberbegriffes. Weitere vorteilhafte Ausgestaltungen der Erfindung ergeben sich aus den Unteransprüchen.

Die Erfindung nach Anspruch 1 geht aus von einem Verfahren zur Erkennung einer breitbandigen Rauschquelle, insbesondere eines Lichtbogens, in einem Gleichspannungs-Verteilungsnetz, bei dem aus dem Gleichspannungs-Verteilungsnetz ein ggf. von der breitbandigen Rauschquelle gestörtes Signal entnommen und über mindestens einen in seiner Frequenzlage veränderbaren Filter geleitet wird. Ein derartiges gattungsgemäßes Verfahren wird dadurch weiterentwickelt, daß die Mittenfrequenz eines Bandfilters mit einstellbarer Mittenfrequenz von einem Mikroprozessor gesteuert in einem vorgebbaren Frequenzbereich zyklisch verändert und innerhalb des Frequenzbereiches bei vorgebbaren Frequenzen die zu der jeweils eingestellten Mittenfrequenz zugehörige spektrale Amplitude des gefilterten Signals ermittelt und dem Mikroprozessor wieder zugeführt wird, woraufhin der Mikroprozessor die Vielzahl der in einem Zyklus derart in dem Frequenzbereich jeweils ermittelten Amplituden auf Kriterien für das Vorliegen einer breitbandigen Rauschquelle in dem Gleichspannungs-Verteilungsnetz untersucht und bei Feststellen einer breitbandigen Rauschquelle ein entsprechendes Signal abgibt. Die Verwendung eines Mikroprozessors sowie die Steuerung der Filterfunktion eines Bandfilters durch den Mikroprozessor und die Auswertung der von dem Bandfilter zurück gelieferten Werte für die Amplituden innerhalb des Filterbereiches vereinfacht die Ermittlung des Amplitudenverhaltens innerhalb des überwachten Frequenzbereiches wesentlich und führt dazu, daß mit nur geringem gerätetechnischem Aufwand das Frequenzspektrum innerhalb des Gleichspannungs-Verteilungsnetzes auf das Vorliegen von Lichtbögen oder dergleichen breitbandigen Rauschquellen überwacht werden kann. Hierbei übernimmt der Mikroprozessor zum einen die Einstellung der Frequenz des Bandfilters, in der beziehungsweise benachbart zu der der aktuelle Wert der Amplitude des durch den Bandfilter gefilterten Signals ermittelt werden soll. Dies kann beispielsweise in weiterer Ausgestaltung von einem Steuerausgang, insbesondere einem Timerausgang des Mikroprozessors übernommen werden, der üblicherweise an Mikroprozessoren ohnehin vorhanden ist. Somit bedarf der Mikroprozessor keinerlei Modifikationen oder muß keine besonders hohen Anforderungen erfüllen. Weiterhin kann der Mikroprozessor die von dem Bandfilter zurück übermittelte Vielzahl der Amplitudenwerte des Signalverlaufes je Zyklus daraufhin überwachen, ob diese Amplitudenwerte bzw. deren spektraler Verlauf typische, für das Auftreten von Lichtbögen charakteristische Kennzeichen aufweisen, wozu ebenfalls die üblicherweise ohnehin vorliegenden Eigenschaften des Mikroprozessors von Nutzen sind und dadurch eine weitere Vereinfachung und Verbilligung der Durchführung des Verfahrens erlauben. Dies gilt umso mehr, wenn innerhalb des Gleichspannungs-Verteilungsnetzes ohnehin Mikroprozessoren vorhanden sind, wie dies beispielsweise im Bereich der Fahrzeugelektrik schon seit langem und mit zunehmender Tendenz der Fall ist. Derartige, ohnehin vorliegende Mikroprozessoren sind teilweise für die von ihnen kontrollierten Prozesse überdimensioniert und können einfach dahingehend modifiziert werden, daß sie diese zusätzliche Aufgabe der Überwachung auf Lichtbögen mit übernehmen. Dies hat weiterhin den Vorteil, daß beispielsweise verschiedene Zweige innerhalb des Gleichspannungs-Verteilungsnetzes jeweils lokal von vor Ort ohnehin vorhandenen Mikroprozessoren überwacht werden können und daher eine Lokalisierung eines tatsächlich aufgetretenen Lichtbogens wesentlich vereinfacht wird.

Von Vorteil ist es, wenn der Bandfilter zu jedem Zeitpunkt jeweils nur einen schmalbandigen Ausschnitt aus dem gesamten Frequenzbereich herausfiltert. Hierdurch läßt sich die Amplitude abhängig von dem jeweils eingestellten Filterbereich sehr schmalbandig und genau ermitteln, wodurch die zyklische Abtastung des gesamten Frequenzbereiches mit hoher Präzision ausgeführt werden kann und die Meßergebnisse für jede Frequenz genaue Werte ohne die Probleme von integrierenden Funktionen ergeben.

Weiterhin ist es von Vorteil, wenn die Mittenfrequenz des Bandfilters zyklisch ganz oder abschnittsweise durch den zu überwachenden Frequenzbereich durchgestimmt wird. Durch die zyklisch ausgeführte, den ganzen oder zumindestens große Teile oder Abschnitte des zu überwachenden Frequenzbereiches scanende Ausführung der Durchstimmung des Bandfilters kann mit hoher Genauigkeit die jeweils vorliegende, frequenzabhängige Amplitude innerhalb des Gleichspannungs-Verteilungsnetzes ermittelt werden. Somit ist man nicht darauf angewiesen, nur an einzelnen, durch die Art der Schaltung fest vorgegebenen Frequenzen die jeweilige Amplitude zu ermitteln und daraus naturgemäß lückenhafte Schlüsse zu ziehen, sondern kann über einen entsprechend breit angelegten Frequenzbereich lückenlos und sehr zeitnah den Verlauf der Amplitude abhängig von der jeweiligen Mittenfrequenz des Bandfilters ermitteln und damit auch schon im Vorfeld bzw. in einer Frühphase des Auftretens von Lichtbögen diese erkennen und entsprechende Gegenmaßnahmen ergreifen.

Von wesentlichem Vorteil für die gerätetechnische Umsetzung des Verfahrens ist es, wenn als Bandfilter ein Switched-Capacitor-Bandfilter verwendet wird. Derartige Bandfilter sind seit langem grundsätzlich bekannt und in ihrem Verhalten sehr gut erforscht und können darüber hinaus durch die Umschaltungsfrequenz, mit der die Kapazität des Filters umgeschaltet wird, einfach und sehr schnell an unterschiedliche Meßfrequenzen angepaßt werden. Durch Verwendung derartiger Switched-Capacitor-Bandfilter läßt sich damit auch vor allem direkt die Amplitude zu dem jeweiligen Frequenzbereich ausfiltern, ohne daß es einer Frequenztransformation oder Frequenzverschiebung bedarf, die bei anderen Filtersystemen wie beispielsweise superheterodynen Filtern nicht zu vermeiden sind. Weiterhin sind derartige Switched-Capacitor-Bandfilter in ihrem Verhalten sehr robust und relativ preisgünstig, so daß insbesondere die Betriebssicherheit auch unter ungünstigen Verhältnissen beispielsweise in Fahrzeugen gewährleistet ist und gleichzeitig die Kosten für die Vorsehung entsprechender Filter relativ wenig ins Gewicht fallen.

In einer ersten vorteilhaften Ausgestaltung ist es denkbar, daß als Kriterium für das Vorliegen einer breitbandigen Rauschquelle ein breitbandig über einen großen Frequenzbereich gegenüber dem normalen Grundrauschen erhöhter, im wesentlichen gleichbleibend hoher Pegel der spektralen Amplitude gewertet wird. Ein Lichtbogen in einem Gleichspannungs-Verteilungsnetz zeichnet sich dadurch aus, daß sich gegenüber dem normalen Grundrauschen im Verteilungsnetz ein deutlich erhöhter, gleichzeitig aber über ein sehr breites Frequenzspektrum gleichmäßig ausgestalteter Amplitudenverlauf ergibt, der nur unwesentliche Unterschiede in der jeweiligen Amplitude aufzeigt. Dieses breitbandige und sich deutlich vom normalen Grundrauschen abhebende Frequenzspektrum kann dazu genutzt werden, das Vorhandensein eines Lichtbogens in einem Gleichspannungs-Verteilungsnetz zu detektieren, wenn wie mit der vorliegenden Erfindung ein entsprechendes Auswerteverfahren für auf dem Gleichspannungs-Verteilungsnetz feststellbare frequenzbezogene Amplitudenwerte und deren Signalverläufe zur Verfügung steht.

Hierbei ist es in weiterer Ausgestaltung auch denkbar, daß das Vorliegen einer breitbandigen Rauschquelle dann als erkannt betrachtet wird, wenn der breitbandig über einen großen Frequenzbereich erhöhte, im wesentlichen gleichbleibend hohe Pegel der spektralen Amplitude einer breitbandigen Rauschquelle um ein mehrfaches über dem normalen Grundrauschen in einem Gleichspannungs-Verteilungsnetz liegt. Damit läßt sich eine klare Trennung zwischen dem normalen Grundrauschen und dem Vorliegen einer breitbandigen Rauschquelle definieren, da die Unterschiede in der Amplitude des ebenfalls relativ gleichmäßigen Grundrauschens und der breitbandigen Rauschquelle sich deutlich voneinander unterscheiden. Weiterhin ist es denkbar, daß das Vorliegen einer breitbandigen Rauschquelle dann als erkannt betrachtet wird, wenn der breitbandig über einen großen Frequenzbereich erhöhte, gleichbleibend hohe Pegel der spektralen Amplitude einer breitbandigen Rauschquelle geringer als diejenigen Amplituden üblicher anderer schmalbandiger Frequenzereignisse oder Schaltereignisse in einem Gleichspannungs-Verteilungsnetz ist. Andere üblicherweise in einem Gleichspannungs-Verteilungsnetz vorkommende Amplitudenverläufe bezogen auf die Frequenzen, die beispielsweise durch anlaufende Verbraucher wie etwa Motoren oder dergleichen oder auch Schwankungen in der Spannungsversorgung etwa eines Fahrzeuges auftreten können, weisen üblicherweise eher schmalbandige frequenzbezogene Verläufe der Amplitude oder breitbandige Verläufe mit unterschiedlich hoher Amplitude (typischerweise ein Linienspektrum bei periodischen Vorgängen bzw. ein kontinuierliches, aber nicht mit konstante r Amplitude verlaufendes Spektrum bei Schaltvorgängen) auf und lassen sich daher auch aufgrund ihrer häufig deutlich höheren Amplitude als das breitbandige Rauschen eines Lichtbogens ebenfalls gut erkennen und bei der Analyse des Frequenzverlaufes eliminieren.

Eine weitere denkbare Ausgestaltung sieht vor, daß die Ansteuerung des Bandfilters hinsichtlich der Frequenzlage und der Größe der Amplitude aufgrund vorhergehender Meßdurchgänge adaptiv angepaßt wird, um im Gleichspannungs-Verteilungsnetz bestimmungsgemäß auftretende schmalbandige Frequenzereignisse oder Schaltereignisse genauer erfassen und von denjenigen breitbandiger Rauschquellen unterscheiden zu können. Hierdurch können beispielsweise periodisch auftretende Frequenzereignisse, die bei immer gleichen oder sehr ähnlichen Frequenzen in einem vorhergehenden Durchstimmvorgang des Bandfilters ermittelt wurden, bei einem nachfolgenden Durchgang einfacher erkannt bzw. auch eliminiert werden, um das breitbandige Rauschen zum Beispiel eines Lichtbogens besser aus dem Frequenzgang herausfiltern zu können.

Eine typische Ausprägung zur Anwendung des Verfahrens beispielsweise innerhalb eines Gleichspannungs-Verteilungsnetzes liegt dann vor, wenn das Gleichspannungs-Bordnetz des Kraftfahrzeuges mit einer Nennspannung von 42 V betrieben wird. Bei derartigen Nennspannungen können beispielsweise aufgrund von Fehlern oder Alterungserscheinungen in Steckkontakten, Schaltern oder dergleichen wesentlich leichter Lichtbögen als bei der bisher üblichen 12 Volt Bordnetzspannung auftreten bzw. zumindest zeitweise bestehen bleiben, so daß die Gefahr von Kabelbränden bzw. Fehlfunktionen innerhalb eines 42 Volt Bordnetzes wesentlich genauer überwacht werden muß bzw. das Vorhandensein von Lichtbögen insgesamt verhindert werden muß.

Von Vorteil für die Anpassung an unterschiedliche Einsatzverhältnisse bzw. unterschiedliche Verhaltensweisen oder auch unterschiedliche Genauigkeiten der Erkennung ist es, wenn die Anpassung der Funktionsweise des Mikroprozessors an jeweils vorliegende Verhältnisse in unterschiedlichen Gleichspannungs-Verteilungsnetzen mittels Parametrisierung und/oder end-of-line Programmierung erfolgt. Hierdurch kann beispielsweise bei Fahrzeugen je nach dem Fahrzeugtyp bzw. auch der elektrischen Ausstattung des Fahrzeuges ein Standard-Schaltkreis zur Erkennung von Lichtbögen genutzt werden, der durch die entsprechende Parametrisierung beispielsweise erst nach dem Einbau in ein spezifisches Fahrzeug mit der jeweiligen elektrischen Ausstattung an genau für dieses Fahrzeug vorliegende Bedürfnisse zur Erkennung von Lichtbögen angepaßt werden kann. Auch können beispielsweise Veränderungen der Funktionsweise des Standard-Schaltkreises aufgrund von Erfahrungen beim dauerhaften Betrieb derartiger Fahrzeuge noch nachträglich in den Standard-Schaltkreis eingespeist werden.

Eine wesentliche Verbesserung ergibt sich dadurch, daß der Mikroprozessor bei Erkennung einer breitbandigen Rauschquelle ein Signal an eine übergeordnete Auswerteeinheit abgibt. Hierdurch kann beispielsweise an einer zentralen Stelle innerhalb des Bordnetzes eines Fahrzeuges eine entsprechende Überwachung vorgenommen und entsprechende Gegenmaßnahmen beim Erkennen eines Lichtbogens oder dergleichen getroffen werden. Beispielsweise kann ein zentrales Steuergerät für die Bordelektronik mit dem Mikroprozessor funktional derart in Verbindung stehen, daß das von dem Mikroprozessor bei Erkennen eines Lichtbogens abgegebene Signal dort zur vollständigen oder teilweisen Stillegung von Verbrauchern bzw. auch entsprechenden Abschnitten des Bordnetzes genutzt werden kann, wobei insbesondere auch der jeweilige Betriebszustand des Fahrzeuges im Hinblick auf sicherheitsrelevante Funktionen in die Entscheidung hinsichtlich der Reaktion mit einbezogen werden kann. So kann beispielsweise in weiterer Ausgestaltung die übergeordnete Auswerteeinheit das Gleichspannungs-Verteilungsnetz im Ganzen oder Teile davon abschalten, um die breitbandige Rauschquelle zu beeinflussen oder zu eliminieren, wobei insbesondere sicherheitsrelevante Bereiche des Gleichspannungs-Verteilungsnetzes weiterhin betrieben werden können.

In weiterer Ausgestaltung kann vorgesehen werden, daß der Frequenzbereich, in dem der Bandfilter durchgestimmt wird, zwischen im wesentlichen 200 Hz und 100 kHz liegt. Innerhalb dieses Frequenzbereiches liegen üblicherweise die entsprechenden Amplitudenverläufe der breitbandigen Rauschquellen im Falle eines Lichtbogens, so daß eine zyklische Durchsuchung dieser Frequenzen eine entsprechende Sicherheit bei der Erkennung eines Lichtbogens gewährleistet.

Die Erfindung betrifft gemäß Anspruch 15 weiterhin eine Vorrichtung zur Erkennung einer breitbandigen Rauschquelle, insbesondere eines Lichtbogens, und insbesondere zur Durchführung eines Verfahrens gemäß Anspruch 1 in einem Gleichspannungs-Verteilungsnetz, die einen in seiner Frequenzlage veränderbaren Filter aufweist. Eine derartige gattungsgemäße Vorrichtung kann insbesondere so ausgestaltet sein, daß ein Bandfilter derart funktional mit einem Mikroprozessor verbunden ist, daß er von dem Mikroprozessor gesteuert in einem vorgebbaren Frequenzbereich zyklisch seine einstellbare Mittenfrequenz verändert, die zu der jeweils eingestellten Mittenfrequenz zugehörige spektrale Amplitude des gefilterten Signals ermittelt und dem Mikroprozessor wieder zuführt, und der Mikroprozessor die spektralen Amplituden auf das Vorliegen einer breitbandigen Rauschquelle untersucht. Hierbei weist der Mikroprozessor als ein leistungsbestimmendes Element eine zentrale Rolle bei der Erfassung der Amplitudenwerte durch den Bandfilter sowie die Auswertung der erfaßten Amplitudenwerte auf, wodurch insbesondere durch die heute zur Verfügung stehende Rechenkapazität derartiger Mikroprozessoren eine schnelle und sichere Erfassung der Amplitudenwerte und deren Auswertung auch in kurzer Zeit bzw. kurzer Folge gewährleistet wird. Insbesondere in Umgebungen, in denen derartige Mikroprozessoren ohnehin vorhanden sind, wie dies heute im Bereich des Fahrzeugbaus absolut üblich ist, können derartige Mikroprozessoren zusätzliche Aufgaben übernehmen, um eine Überwachung des Gleichspannungs-Bordnetzes beispielsweise eines Fahrzeuges zu übernehmen. Hierdurch werden nur unwesentliche Mehrkosten verursacht, wodurch die Wirtschaftlichkeit zur Nutzung des erfindungsgemäßen Verfahrens wesentlich gesteigert werden kann. Darüber hinaus können durch eine derartige Schaltungsanordnung Einflüsse aufgrund von Störstrahlungen (elektromagnetische Verträglichkeit) durch diesen einfachen Aufbau der Schaltung und damit nur geringe Störanfälligkeit der einzelnen Komponenten und auch der gesamten Vorrichtung verhindert werden.

Von Vorteil ist es, wenn der Bandfilter ein Switched-Capacitor-Bandfilter ist. Ein derartiger Switch-Capacitor-Bandfilter stellt eine relativ günstige und technisch zuverlässige Möglichkeit dar, direkt und ohne Frequenzverschiebungen oder dergleichen Amplituden aus einem sehr schmalbandigen Bereich eines Frequenzspektrums heraus zu bestimmen und an den Mikroprozessor zurück zu übermitteln. Hierbei ist in weiterer Ausgestaltung vorgesehen, daß der Frequenz-Mittelwert des Filterbereichs des Switched-Capacitor-Bandfilters genau die von dem Timer des Mikroprozessors vorgegebene Frequenz aufweist. Der Timer des Mikroprozessors gibt damit eine Frequenz an den Switched-Capacitor-Bandfilter vor, die dieser sehr genau einhält und innerhalb der zugeordneten Frequenz bzw. des entsprechenden Frequenzbereiches sehr schmalbandig die vorliegende Amplitude aus dem Gleichspannungs-Verteilungsnetz bestimmt. Damit entfallen sonst übliche Notwendigkeiten aufgrund nicht vermeidbarer Chargenunterschiede, unterschiedlichen Temperaturverhaltens oder dergleichen der elektronischen Bauteile, um die jeweilige Filterfrequenz zu bestimmen.

Von Vorteil ist es weiterhin, wenn das entnommene, ggf. von der breitbandigen Rauschquelle gestörte Signal über einen Verstärker auf den Bandfilter aufgeschaltet ist. Hierdurch können entsprechend größere Rauschabstände ohne Verlust an Genauigkeit hergestellt werden, die die Erfassung der Amplitudenhöhe bzw. deren U n-terscheidung in breitbandiges Rauschen und einzelne unbedenkliche Frequenzgänge verbessert.

Zur Absicherung ist es ebenfalls von Vorteil, wenn Kondensatoren zwischen dem Gleichspannungs-Verteilungsnetz und der Vorrichtung zur Erkennung der breitbandigen Rauschquelle angeordnet sind und das Gleichspannungs-Verteilungsnetz von der Vorrichtung trennen.

In einer ersten denkbaren Ausgestaltung kann das Ausgangssignal des Bandfilters über einen Gleichrichter auf den Mikroprozessor aufgeschaltet werden. Hierbei wird die Gleichrichtung innerhalb des Gleichrichters vorgenommen und der Mikroprozessor kann entsprechend einfacher hinsichtlich des Signaleingangs ausgestaltet sein. Hierbei wird dann in vorteilhafter Ausgestaltung das Ausgangssignal des Bandfilters auf einen Analogeingang des Mikroprozessors aufgeschaltet und kann dort direkt ausgewertet werden.

Es ist ebenfalls in anderer Ausgestaltung denkbar, daß das Ausgangssignal des Bandfilters direkt auf den Mikroprozessor aufgeschaltet ist und der Mikroprozessor selbst den Wechselanteil des Signales auswertet. Hierdurch kann eine weitere Vereinfachung des gerätetechnischen Konzeptes erreicht werden.

Es ist darüber hinaus denkbar, daß der Mikroprozessor einen Signalprozessor aufweist oder dieser dem Mikroprozessor vorgelagert ist, der die Signalauswertung der von dem Bandfilter bereitgestellten Amplitudenwerte übernimmt. Derartige Signalprozessoren haben den Vorteil einer schnellen Signalverarbeitung, ohne eine zu hohe Auslastung des eigentlichen Mikroprozessors zu bedingen. Daher kann der Mikroprozessor mit einem kombinierten Signalprozessor während der eigentlichen Signalauswertung durch den Signalprozessor parallel weitere Aufgaben übernehmen und beispielsweise kombiniert in einem Fahrzeug für andere echtzeitkritische Systeme zuständig sein.

Von Vorteil ist es für die Anwendung in einem Fahrzeug, wenn die übergeordnete Auswerteeinheit und der Mikroprozessor über einen CAN-Bus eines Kraftfahrzeuges miteinander funktional verbunden sind. Hierdurch wird auf dem CAN-Bus beim Erkennen eines Lichtbogens lediglich ein entsprechender Signalzustand ausgelöst, der an anderer Stelle des CAN-Bus dann einen entsprechenden Überprüfungsvorgang oder entsprechende Reaktionen auslöst.

Eine besonders bevorzugte Ausführungsform der Vorrichtung zur Durchführung des erfindungsgemäßen Verfahrens gemäß Anspruch 1 zeigt die Zeichnung.

Es zeigen:
- Fig. 1: - einen prinziphaften Schaltungsaufbau in Form eines Blockschaltbildes für die Einzelelemente einer erfindungsgemäßen Vorrichtung,
- Fig. 2: - einen schematisch aufgezeichneten Amplitudenverlauf beim Vorliegen eines Lichtbogens in einem Gleichspannungs-Verteilungsnetz.

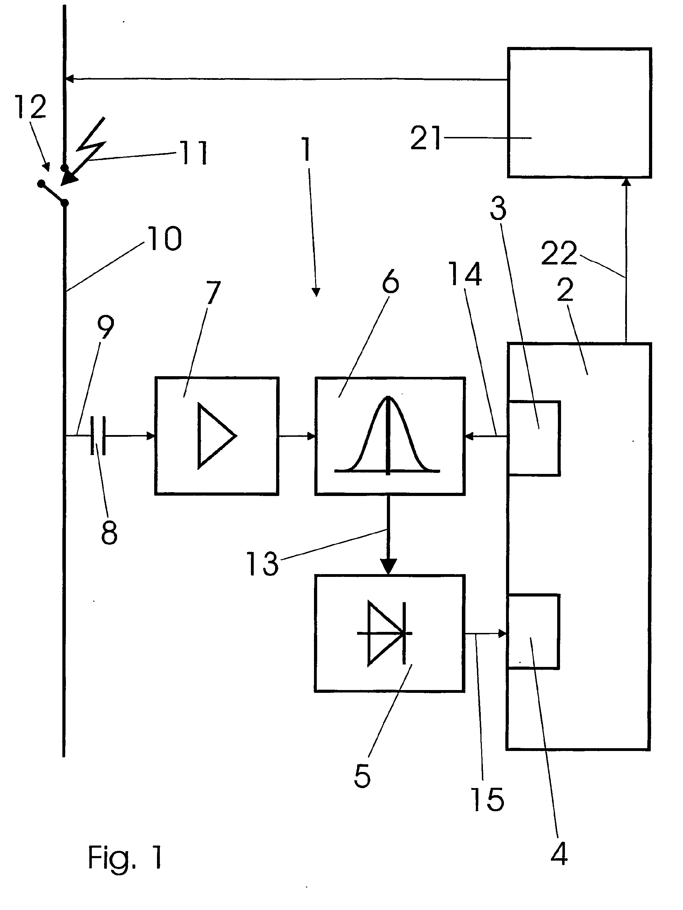

In der Figur 1 ist in Form eines Blockschaltbildes der grundsätzliche Aufbau einer Vorrichtung 1 zur Durchführung des erfindungsgemäßen Verfahrens dargestellt, wobei nur die wesentlichen Funktionsbaugruppen der Vorrichtung 1 aufgezeichnet sind.

Die Vorrichtung 1 dient zur Erkennung eines breitbandigen Rauschens 11 in einem Gleichspannungs-Verteilungsnetz 10 beispielsweise eines Kraftfahrzeuges oder dergleichen, in dem etwa an einem Schalter 12 oder einer anderen Stelle das breitbandige Rauschen 11 in Form eines Lichtbogens durch eine Fehlfunktion beispielsweise des Schalters 12 hervorgerufen wird. Es versteht sich von selbst, daß jegliche Arten breitbandigen Rauschens 11 hiermit gemeint sein sollen, wie sie beispielsweise durch Kabelbruch, korrodierte oder sonstwie beschädigte oder lockere Übergangstellen beispielsweise in Steckern oder dergleichen hervorgerufen werden können.

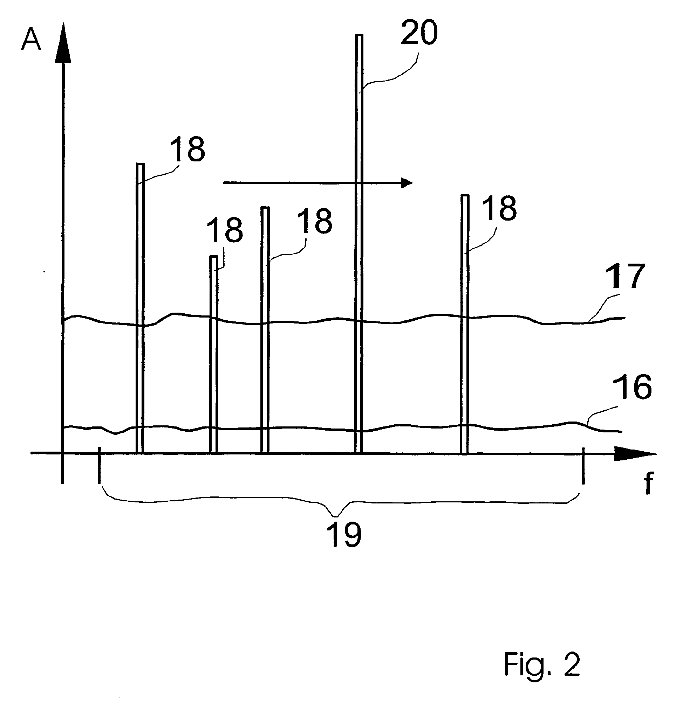

Die Vorrichtung 1 weist einen Mikroprozessor 2 grundsätzlich bekannter Bauart auf, der hier nur hinsichtlich seiner Funktion eines Timers 3 und eines Signaleinganges 4 näher dargestellt ist. Das aus dem Gleichspannungs-Verteilungsnetz 10 ausgekoppeltes Signal 9 wird über einen Kondensator 8 und einen Verstärker 7 auf einen Bandfilter 6 aufgeschaltet, der sehr schmalbandig arbeitet und beispielsweise in Form eines Switched-Capacitor-Bandfilters ausgebildet ist. Derartige Bandfilter 6 sind ebenfalls seit langem bekannt und sollen hier nur soweit erläutert werden, wie dies für die Ausführung dieser Erfindung von Belang ist. Ein derartiger Bandfilter 6 wird von dem Timerausgang 3 des Mikroprozessors 2 durch ein Timersignal 14 beaufschlagt und verändert gesteuert durch dieses Timersignal 14 die Lage seiner Mittenfrequenz zur Filterung des von dem Verstärker 7 auf den Bandfilter 6 aufgegebenen Signals 24. Diese Mittenfrequenz wird aufgrund des Verhaltens des Bandfilters 6 sehr genau eingehalten und das Filterverhalten ist sehr schmalbandig, so daß als Ausgangssignal 13 des Bandfilters 6 ein sehr gut und genau erfaßter Amplitudenwert für genau die von dem Timersignal 14 vorgegebene Mittenfrequenz des Bandfilters 6 erzeugt wird. Wird nun das Timersignal 14 durch den Mikroprozessor 2 schnell so verändert, daß das Timersignal 14 von einer Minimalfrequenz zu einer Maximalfrequenz gefahren wird und dann zyklisch wieder bei der Minimalfrequenz beginnt, so scannt der Bandfilter 6 zyklisch den zwischen der Minimalfrequenz und der Maximalfrequenz liegenden Frequenzbereich 19 in Form eines sehr schmalbandigen Fensters 20 und sorgt damit dafür, daß ein Profil der jeweils gemessenen Amplituden erfaßt werden kann. Diese Ausgangssignale 13 des Bandfilters 6 werden beispielsweise über einen Gleichrichter 5 als Eingangssignal 15 auf einen Analogeingang 4 des Mikroprozessors 2 aufgeschaltet und damit stehen in dem Mikroprozessor 2 die frequenzbezogenen Amplituden des von dem Bandfilter 6 gefilterten Signals 13 sowie gleichzeitig die jeweilige Mittenfrequenz des Bandfilters 6 entsprechend dem Timersignal 14 zur Verfügung und können zu dem in der Figur 2 beispielhaft dargestellten Verlauf der Amplituden über der Frequenz innerhalb des Frequenzbereiches 19 verarbeitet werden. Hierbei ist es auch möglich, daß das Ausgangssignal 13 des Bandfilters 6 bei geeigneter Ausgestaltung direkt auf den dann entsprechend modifizierten Eingang 4 des Mikroprozessors 2 aufgeschaltet wird. Ebenfalls ist es denkbar, daß hier ein Signalprozessor zwischengeschaltet wird, der die Vorverarbeitung der Ausgangssignale 13 über die Frequenz des Frequenzbereiches 19 vornimmt.

Der Mikroprozessor 2 verfügt damit über die beiden wichtigen Informationen aus der Auswertung des Signales 9 aus dem Gleichspannungs-Verteilungsnetz 10, nämlich der jeweils zueinander gehörigen Frequenz aufgrund des Timersignals 14 und dem daraus ermittelten Signal 15 für die Amplitude zu der jeweiligen Frequenz. Es hat sich nun herausgestellt, daß beim Vorliegen eines breitbandigen Rauschens 11 in Form etwa eines Lichtbogens der Amplitudenverlauf über die Frequenz so ausgestaltet ist, daß ein im wesentlichen gleichbleibender Amplitudenverlauf 17 nahezu über den gesamten Frequenzbereich 19 vorliegt, der sich deutlich von dem wesentlich geringeren Grundrauschen 16 abhebt und daher von diesem gut zu unterscheiden ist. Einzelne beispielsweise aufgrund von bestimmungsgemäßen Vorgängen innerhalb des Gleichspannungs-Verteilungsnetzes hervorgerufene Amplituden 18 sind üblicherweise schmalbandig bzw. periodisch schmalbandig und können ebenfalls gut von dem breitbandigen Rauschen 17 unterschieden werden.

Erkennt der Mikroprozessor 2 aufgrund der Auswertung der am Eingang 4 anliegenden Amplituden, daß ein derartiges breitbandiges Rauschen 11 in dem Gleichspannungs-Verteilungsnetz 10 vorliegt, so kann dies als Kriterium für das Vorliegen eines Lichtbogens oder dergleichen gedeutet werden und es kann ein entsprechendes Warnsignal 22 an eine übergeordnete Auswerteeinheit 21 gesandt werden, die beispielsweise in Form von weiteren Signal 23 entsprechende Gegenmaßnahmen in dem Gleichspannungs-Verteilungsnetz 10 veranlaßt. Derartige Maßnahmen können beispielsweise darin bestehen, daß einzelne Zweige oder auch das ganze Gleichspannungs-Verteilungsnetz 10 zu mindestens kurzzeitig abgeschaltet und damit ein das breitbandige Rauschen 11 verursachender Lichtbogen unterbrochen wird.

Die Vorrichtung 1 zeichnet sich dadurch aus, daß mit sehr geringem operativen Aufwand und unter nahezu allen Umgebungsbedingungen wie beispielsweise auch in Kraftfahrzeugen bei unterschiedlichen Betriebsbedingungen eine genaue Erfassung breitbandigen Rauschens 11 z.B. aufgrund eines Lichtbogens durchgeführt werden kann, darüber hinaus ist diese Anordnung aufgrund ihres einfachen Aufbaus besonders kostengünstig und EMV-fest. Damit liegen alle Eigenschaften zur Integration einer derartigen Vorrichtung 1 in Bordnetze 10 von Fahrzeugen beispielsweise mit 42 Volt Bordnetzen vor.

### Sachnummernliste

- 1 -: Erkennungsschaltung
- 2 -: Mikroprozessor
- 3 -: Timer
- 4 -: Analogeingang
- 5 -: Gleichrichter
- 6 -: Bandfilter
- 7 -: Verstärker
- 8 -: Kondensator
- 9 -: ausgekoppeltes Signal
- 10 -: Gleichspannungs-Verteilungsnetz
- 11 -: Lichtbogen
- 12 -: Schalter
- 13 -: gefilterte Signal
- 14 -: Timer-Signal
- 15 -: verstärktes Signal
- 16 -: Grundrauschen
- 17 -: Rauschen der breitbandigen Rauschquelle
- 18 -: schmalbandige Frequenzereignisse
- 19 -: Frequenzbereich
- 20 -: schmalbandiger Ausschnitt Filterung
- 21 -: Auswerteeinheit
- 22 -: Erkennungssignal
- 23 -: Schaltsignal
- 24 -: verstärktes Signal

## Patentansprüche

1. Verfahren zur Erkennung einer breitbandigen Rauschquelle (11), insbesondere eines Lichtbogens, in einem Gleichspannungs-Verteilungsnetz (10) insbesondere in Bordnetzen in Kraftfahrzeugen, bei dem aus dem Gleichspannungs-Verteilungsnetz (10) ein ggf. von der breitbandigen Rauschquelle (11) gestörtes Signal (9) entnommen und über mindestens einen in seiner Frequenzlage veränderbaren Filter (6) geleitet wird, wobei die Mittenfrequenz eines Bandfilters (6) mit einstellbarer Mittenfrequenz von einem Mikroprozessor (2) gesteuert in einem vorgebbaren Frequenzbereich (19) zyklisch verändert und innerhalb des Frequenzbereiches (19) bei vorgebbaren Frequenzen die zu der jeweils eingestellten Mittenfrequenz zugehörige spektrale Amplitude des gefilterten Signals (13) ermittelt und dem Mikroprozessor (2) wieder zugeführt wird, woraufhin der Mikroprozessor (2) die derart in dem Frequenzbereich (19) jeweils ermittelten Amplituden auf Kriterien für das Vorliegen einer breitbandigen Rauschquelle (11) in dem Gleichspannungs-Verteilungsnetz (10) untersucht und bei Feststellen einer breitbandigen Rauschquelle (11) ein entsprechendes Signal (22) abgibt, wobei als Bandfilter (6) ein Switched-Capacitor-Bandfilter verwendet wird.

2. Verfahren nach Anspruch 1, **dadurch gekennzeichnet, daß** die Mittenfrequenz des Bandfilters (6) von einem Steuerausgang (3), insbesondere einem Timerausgang des Mikroprozessors (2) vorgegeben wird.

3. Verfahren nach einem der Ansprüche 1 oder 2, **dadurch gekennzeichnet, daß** der Bandfilter (6) zu jedem Zeitpunkt jeweils nur einen schmalbandigen Ausschnitt (20) aus dem gesamten Frequenzbereich (19) herausfiltert.

4. Verfahren nach einem der vorstehenden Ansprüche, **dadurch gekennzeichnet, daß** die Mittenfrequenz des Bandfilters (6) zyklisch ganz oder abschnittsweise durch den zu überwachenden Frequenzbereich (19) durchgestimmt wird.

5. Verfahren nach einem der vorstehenden Ansprüche, **dadurch gekennzeichnet, daß** als Kriterium für das Vorliegen einer breitbandigen Rauschquelle (11) ein breitbandig über einen großen Frequenzbereich (19) gegenüber über dem normalen Grundrauschen (16) erhöhter, im wesentlichen gleichbleibend hoher Pegel der spektralen Amplitude gewertet wird.

6. Verfahren nach Anspruch 5, **dadurch gekennzeichnet, daß** das Vorliegen einer breitbandigen Rauschquelle (11) dann als erkannt gilt, wenn der breitbandig über einen großen Frequenzbereich (19) erhöhte, im wesentlichen gleichbleibend hohe Pegel der spektralen Amplitude einer breitbandigen Rauschquelle (11) um ein mehrfaches über dem normalen Grundrauschen (16) in einem Gleichspannungs-Verteilungsnetz (10) liegt.

7. Verfahren nach einem der Ansprüche 5 oder 6, **dadurch gekennzeichnet, daß** das Vorliegen einer breitbandigen Rauschquelle (11) dann als erkannt gilt, wenn der breitbandig über einen großen Frequenzbereich (19) erhöhte, gleichbleibend hohe Pegel der spektralen Amplitude einer breitbandigen Rauschquelle (11) geringer als diejenigen Amplituden üblicher anderer schmalbandiger Frequenzereignisse (18) oder Schaltereignisse in einem Gleichspannungs-Verteilungsnetz (10) ist.

8. Verfahren nach einem der vorstehenden Ansprüche, **dadurch gekennzeichnet, daß** die Ansteuerung des Bandfilters (6) hinsichtlich der Frequenzlage und der Größe der Amplitude aufgrund vorhergehender Meßdurchgänge adaptiv angepaßt wird, um im Gleichspannungs-Verteilungsnetz (10) bestimmungsgemäß auftretende schmalbandige Frequenzereignisse (18) oder Schaltereignisse genauer erfassen und von denjenigen breitbandiger Rauschquellen (11) unterscheiden zu können.

9. Verfahren nach einem der vorstehenden Ansprüche, **dadurch gekennzeichnet, daß** als Gleichspannungs-Verteilungsnetz (10) das Gleichspannungs-Bordnetz eines Kraftfahrzeuges überwacht wird.

10. Verfahren nach Anspruch 9, **dadurch gekennzeichnet, daß** das Gleichspannungs-Bordnetz (10) des Kraftfahrzeuges mit einer Nennspannung von 42 V betrieben wird.

11. Verfahren nach einem der vorstehenden Ansprüche, **dadurch gekennzeichnet, daß** die Anpassung der Funktionsweise des Mikroprozessors (2) an jeweils vorliegende Verhältnisse in unterschiedlichen Gleichspannungs-Verteilungsnetzen (10) mittels Parametrisierung und/oder end-of-line Programmierung erfolgt.

12. Verfahren nach einem der vorstehenden Ansprüche, **dadurch gekennzeichnet, daß** der Mikroprozessor (2) bei Erkennung einer breitbandigen Rauschquelle (11) ein Signal (22) an eine übergeordnete Auswerteeinheit (21) abgibt.

13. Verfahren nach Anspruch 12, **dadurch gekennzeichnet, daß** die übergeordnete Auswerteeinheit (21) das Gleichspannungs-Verteilungsnetz (10) im Ganzen oder Teile davon abschaltet, um die breitbandige Rauschquelle (11) zu beeinflussen oder zu eliminieren.

14. Verfahren nach einem der vorstehenden Ansprüche, **dadurch gekennzeichnet, daß** der Frequenzbereich (19), in dem der Bandfilter (6) durchgestimmt wird, zwischen im wesentlichen 200 Hz und 100 kHz liegt.

15. Vorrichtung (1) zur Erkennung einer breitbandigen Rauschquelle (11), insbesondere eines Lichtbogens, insbesondere zur Durchführung eines Verfahrens nach Anspruch 1 in einem Gleichspannungs-Verteilungsnetz (10), aufweisend einen in seiner Frequenzlage veränderbaren Filter (6),
**dadurch gekennzeichnet, daß**
ein Bandfilter (6) derart funktional mit einem Mikroprozessor (2) verbunden ist, daß er von dem Mikroprozessor (2) gesteuert in einem vorgebbaren Frequenzbereich (19) zyklisch seine einstellbare Mittenfrequenz verändert, die zu der jeweils eingestellten Mittenfrequenz zugehörige spektrale Amplitude des gefilterten Signals (13) ermittelt und dem Mikroprozessor (2) wieder zuführt, und der Mikroprozessor (2) die spektralen Amplituden auf das Vorliegen einer breitbandigen Rauschquelle (11) untersucht, wobei der Bandfilter (6) ein Switched-Capacitor Bandfilter ist.

16. Vorrichtung (1) nach Anspruch 15, **dadurch gekennzeichnet, daß** der Frequenz-Mittelwert des Filterbereichs des Switched-Capacitor-Bandfilters (6) genau die von dem Timer (3) des Mikroprozessors (2) vorgegebene Frequenz (14) aufweist.

17. Vorrichtung (1) nach einem der Ansprüche 15 bis 16, **dadurch gekennzeichnet, daß** das entnommene, ggf. von der breitbandigen Rauschquelle (11) gestörte Signal (9) über einen Verstärker (7) auf den Bandfilter (6) aufgeschaltet ist.

18. Vorrichtung (1) nach einem der Ansprüche 15 bis 17, **dadurch gekennzeichnet, daß** Kondensatoren (8) zwischen dem Gleichspannungs-Verteilungsnetz (10) und der Vorrichtung (1) zur Erkennung der breitbandigen Rauschquelle (11) angeordnet sind.

19. Vorrichtung (1) nach einem der Ansprüche 15 bis 18, **dadurch gekennzeichnet, daß** das Ausgangssignal (13) des Bandfilters (6) über einen Gleichrichter (5) auf den Mikroprozessor (2) aufgeschaltet ist.

20. Vorrichtung (1) nach Anspruch 19, **dadurch gekennzeichnet, daß** das Ausgangssignal (13) des Bandfilters (6) auf einen Analogeingang (4) des Mikroprozessors (2) aufgeschaltet ist.

21. Vorrichtung (1) nach einem der Ansprüche 15 bis 18, **dadurch gekennzeichnet, daß** das Ausgangssignal (13) des Bandfilters (6) direkt auf den Mikroprozessor (2) aufgeschaltet ist und der Mikroprozessor (2) selbst den Wechselanteil des Signales (13) auswertet.

22. Vorrichtung nach einem der Ansprüche 15 bis 21, **dadurch gekennzeichnet, daß** der Mikroprozessor (2) einen Signalprozessor aufweist, der die Signalauswertung der von dem Bandfilter (6) gemessenen Amplitudenwerte übernimmt.

23. Vorrichtung nach einem der Ansprüche 15 bis 22, **dadurch gekennzeichnet, daß** die übergeordnete Auswerteeinheit (21) und der Mikroprozessor (2) über einen CAN-Bus (22) eines Kraftfahrzeuges miteinander funktional verbunden sind.

24. Vorrichtung nach einem der Ansprüche 15 bis 23, **dadurch gekennzeichnet, daß** das Gleichspannungs-Verteilungsnetz (10) das Gleichspannungs-Bordnetz eines Kraftfahrzeuges ist.

25. Vorrichtung nach Anspruch 24, **dadurch gekennzeichnet, daß** der Mikroprozessor (2) ein in einem Bordnetz eines Kraftfahrzeuges oder dgl. ohnehin vorhandener Mikroprozessor (2) ist.

## Claims

1. A method of detecting a wideband noise source (11), in particular an arc, in a dc voltage distribution network (10), in particular in on-board networks in motor vehicles, in which a signal (9) which is possibly suffering from interference from the wideband noise source (11) is taken from the dc voltage distribution network (10) and passed by way of at least one filter (6) which is variable in its frequency position, wherein the centre frequency of a band-pass filter (6) with adjustable centre frequency is cyclically altered controlled by a microprocessor (2) in a predeterminable frequency range (19) and within the frequency range (19) at predeterminable frequencies the spectral amplitude, associated with the respectively set centre frequency, of the filtered signal (13) is ascertained and passed to the microprocessor (2) again, whereupon the microprocessor (2) investigates the amplitudes respectively ascertained in the frequency range (19) for criteria for the presence of a wideband noise source (11) in the dc voltage distribution network (10) and delivers a corresponding signal (22) when a wideband noise source (11) is found, wherein a switched-capacitor band-pass filter is used as the band-pass filter (6).

2. A method according to claim 1 **characterised in that** the centre frequency of the band-pass filter (6) is predetermined by a control output (3), in particular a timer output of the microprocessor (2).

3. A method according to one of claims 1 and 2 **characterised in that** the band-pass filter (6) at any time respectively filters out only a narrow-band portion (20) from the entire frequency range (19).

4. A method according to one of the preceding claims **characterised in that** the centre frequency of the band-pass filter (6) is tuned cyclically entirely or portion-wise by the frequency range (19) to be monitored.

5. A method according to one of the preceding claims **characterised in that** a level of the spectral amplitude, which remains of substantially the same height and which is increased in wideband relationship over a large frequency range (19) in relation to the normal background noise (16) is assessed as the criterion of the presence of a wideband noise source (11).

6. A method according to claim 5 **characterised in that** the presence of a wideband noise source (11) is deemed to be detected when the level of the spectral amplitude of a wideband noise source (11), which remains of substantially the same height and is increased in wideband relationship over a large frequency range (19), is a multiple above the normal background noise (16) in a dc voltage distribution network (10).

7. A method according to one of claims 5 and 6 **characterised in that** the presence of a wideband noise source (11) is deemed to be detected when the level of the spectral amplitude of a wideband noise source (11), which remains of substantially the same height and is increased in wideband relationship over a large frequency range (19), is less than those amplitudes of usual other narrow-band frequency events (18) or switching events in a dc voltage distribution network (10).

8. A method according to one of the preceding claims **characterised in that** actuation of the band-pass filter (6) is adaptively adapted in respect of the frequency position and the magnitude of the amplitude on the basis of preceding measurement passes in order to be able to detect more accurately narrow-band frequency events (18) or switching events which properly occur in the dc voltage distribution network (10) and distinguish them from those of wideband noise sources (11).

9. A method according to one of the preceding claims **characterised in that** the dc voltage on-board network of a motor vehicle is monitored as the dc voltage distribution network (10).

10. A method according to claim 9 **characterised in that** the dc voltage on-board network (10) of the motor vehicle is operated with a nominal voltage of 42 V.

11. A method according to one of the preceding claims **characterised in that** adaptation of the mode of operation of the microprocessor (2) to respectively occurring conditions in different dc voltage distribution networks (10) is effected by means of parametrisation and/or end-of-line programming.

12. A method according to one of the preceding claims **characterised in that** upon detection of a wideband noise source (11) the microprocessor (2) delivers a signal (22) to a higher-level evaluation unit (21).

13. A method according to claim 12 **characterised in that** the higher-level evaluation unit (12) switches off the dc voltage distribution network (10) entirely or in parts thereof in order to influence or eliminate the wideband noise source (11).

14. A method according to one of the preceding claims **characterised in that** the frequency range (19) in which the band-pass filter (6) is tuned is between substantially 200 Hz and 100 Hz.

15. Apparatus (1) for detecting a wideband noise source (11), in particular an are, in particular for carrying out a method according to claim 1 in a dc voltage distribution network (10), having a filter (6) which is variable in its frequency position,
**characterised in that**
a band-pass filter (6) is functionally connected to a microprocessor (2) in such a way that controlled by the microprocessor (2) in a predeterminable frequency range (19) it cyclically alters its adjustable centre frequency, ascertains the spectral amplitude, associated with the respectively set centre frequency, of the filtered signal (13) and passes it to the microprocessor (2) again and the microprocessor (2) investigates the spectral amplitudes for the presence of a wideband noise source (11), wherein the band-pass filter (6) is a switched-capacitor band-pass filter.

16. Apparatus (1) according to claim 15 **characterised in that** the frequency centre value of the filter range of the switched-capacitor band-pass filter (6) has precisely the frequency (14) predetermined by the timer (3) of the microprocessor (2).

17. Apparatus (1) according to one of claims 15 to 16 **characterised in that** the signal (9) which is taken off and which is possibly suffering from interference from the wideband noise source (11) is applied to the band-pass filter (6) by way of an amplifier (7).

18. Apparatus (1) according to one of claims 15 to 17 **characterised in that** capacitors (8) are disposed between the dc voltage distribution network (10) and the apparatus (1) for detecting the wideband noise source (11).

19. Apparatus (1) according to one of claims 15 to 18 **characterised in that** the output signal (13) of the band-pass filter (6) is applied to the microprocessor (2) by way of a rectifier (5).

20. Apparatus (1) according to claim 19 **characterised in that** the output signal (13) of the band-pass filter (6) is applied to an analog input (4) of the microprocessor (2).

21. Apparatus (1) according to one of claims 15 to 18 **characterised in that** the output signal (13) of the band-pass filter (6) is applied directly to the microprocessor (2) and the microprocessor (2) itself evaluates the alternating component of the signal (13).

22. Apparatus according to one of claims 15 to 21 **characterised in that** the microprocessor (2) has a signal processor which implements signal evaluation of the amplitude values measured by the band-pass filter (6).

23. Apparatus according to one of claims 15 to 22 **characterised in that** the higher-level evaluation unit (21) and the microprocessor (2) are functionally connected together by way of a CAN-bus (22) of a motor vehicle.

24. Apparatus according to one of claims 15 to 23 **characterised in that** the dc voltage distribution network (10) is the dc voltage on-board network of a motor vehicle.

25. Apparatus according to claim 24 **characterised in that** the microprocessor (2) is a microprocessor (2) which is present in any case in an on-board network of a motor vehicle or the like.

## Revendications

1. Procédé pour reconnaître une source de bruit (11), à large bande, en particulier un arc, dans un réseau de distribution de tension continue (10), en particulier dans des réseaux de bord sur des véhicules automobiles, dans lesquels un signal (9) perturbé par la source de bruit (11) à large bande est prélevé sur le réseau de distribution de tension continue (10) et est acheminé au moyen d'au moins un filtre (6) variable dans sa position en fréquence, la fréquence centrale d'un filtre passe-bande (6) étant modifiée de façon cyclique avec une fréquence centrale réglable commandée par un microprocesseur (2) dans une plage de fréquences (19) prédéfinissable et l'amplitude spectrale, spécifique à la fréquence centrale respectivement réglée, du signal (13) filtré étant déterminée à l'intérieur de la plage de fréquences (19) dans le cas de fréquences prédéfinissables, et étant amenée à nouveau au microprocesseur (2), après quoi le microprocesseur (2) analyse les amplitudes respectivement déterminées dans la plage de fréquences (19) au niveau des critères pour la présence d'une source de bruit (11) à large bande dans le réseau de distribution de tension continue (10) et émettant un signal (22) approprié en cas de constatation d'une source de bruit (11) à large bande, un filtre passe-bande à capacités commutées (Switched-Capacitor) étant utilisé comme filtre passe-bande (6).

2. Procédé selon la revendication 1, **caractérisé en ce que** la fréquence centrale du filtre passe-bande (6) est prédéfinie par une sortie de commande (3), en particulier une sortie de minuterie du microprocesseur (2).

3. Procédé selon l'une quelconque des revendications 1 ou 2, **caractérisé en ce que** le filtre passe-bande (6) élimine par filtrage à tout instant à chaque fois seulement un extrait (20) à bande étroite de la plage de fréquences (19) globale.

4. Procédé selon l'une quelconque des revendications précédentes, **caractérisé en ce que** la fréquence centrale du filtre passe-bande (6) est ajustée de façon cyclique tout ou par section par la plage de fréquences (19) à surveiller.

5. Procédé selon l'une quelconque des revendications précédentes, **caractérisé en ce qu'**un niveau de l'amplitude spectrale, qui est élevé avec une bande large sur une grande plage de fréquences (19) par rapport au bruit de fond (16) normal et sensiblement uniforme, est considéré comme critère pour la présence d'une source de bruit (11) à large bande.

6. Procédé selon la revendication 5, **caractérisé en ce que** la présence d'une source de bruit (11) à large bande est considérée comme détectée dans les cas où le niveau élevé avec une large bande sur une grande plage de fréquences (19) et sensiblement uniforme, de l'amplitude spectrale d'une source de bruit (11) à large bande est plusieurs fois supérieur au bruit de fond (16) normal dans un réseau de distribution de tension continue (10).

7. Procédé selon l'une des revendications 5 ou 6, **caractérisé en ce que** la présence d'une source de bruit (11) à large bande est considérée comme reconnue lorsque le niveau, élevé avec une large bande sur une grande plage de fréquences (19) et sensiblement uniforme, de l'amplitude spectrale d'une source de bruit (11) à large bande est inférieur aux amplitudes d'autres événements de fréquence (18) ou événements de commutation à bande étroite classiques dans un réseau de distribution de tension continue (10).

8. Procédé selon l'une quelconque des revendications précédentes, **caractérisé en ce que** l'activation du filtre passe-bande (6) est ajustée de façon adaptative en ce qui concerne la position en fréquence et la grandeur de l'amplitude sur la base de passages de mesure précédents, afin de pouvoir détecter de façon plus précise des événements de fréquence (18) ou des événements de commutation à bande étroite qui apparaissent dans le réseau de distribution de tension continue (10) conformément à ce qui est prévu et de pouvoir les différencier des sources de bruit (11) à large bande.

9. Procédé selon l'une quelconque des revendications précédentes, **caractérisé en ce que** le réseau de bord à tension continue d' un véhicule est surveillé comme réseau de distribution de tension continue (10).

10. Procédé selon la revendication 9, **caractérisé en ce que** le réseau de bord à tension continue (10) du véhicule est exploité avec une tension nominale de 42 V.

11. Procédé selon l'une quelconque des revendications précédentes, **caractérisé en ce que** l'adaptation du mode de fonction du microprocesseur (2) à des conditions respectivement présentes s'effectue dans différents réseaux de distribution de tension continue (10) par un paramétrage et/ou une programmation de fin de ligne (end-of-line).

12. Procédé selon l'une quelconque des revendications précédentes, **caractérisé en ce que** le microprocesseur (2) envoie un signal (22) à une unité d'analyse (21) prioritaire en cas de détection d'une source de bruit (11) à large bande.

13. Procédé selon la revendication 12, **caractérisé en ce que** l'unité d'analyse (21) prioritaire déconnecte le réseau de distribution de tension continue (10) en totalité ou en partie, afin d'influencer ou d'éliminer la source de bruit (11) à large bande.

14. Procédé selon l'une quelconque des revendications précédentes, **caractérisé en ce que** la plage de fréquences (19), dans laquelle le filtre passe-bande (6) est ajusté, se situe entre sensiblement 200 Hz et 100 kHz.

15. Dispositif (1) pour reconnaître une source de bruit (11) à large bande, en particulier un arc, en particulier pour mettre en oeuvre un procédé selon la revendication 1 dans un réseau de distribution de tension continue (10), présentant un filtre (6) variable dans sa position en fréquence,
**caractérisé en ce qu'**un filtre passe-bande (6) est relié au plan fonctionnel à un microprocesseur (2) de telle sorte qu'il modifie de façon cyclique sa fréquence centrale réglable, commandée par le microprocesseur (2), dans une plage de fréquences (19) prédéfinissable, détermine l'amplitude spectrale, spécifique à la fréquence centrale respectivement réglée, du signal filtré (13) et l'amène au microprocesseur (2) et le microprocesseur (2) analyse les amplitudes spectrales au niveau de la présence d'une source de bruit (11) à large bande, le filtre passe-bande (6) étant un filtre passe-bande à capacité commutées (Switched-Capacitor).

16. Dispositif (1) selon la revendication 15, **caractérisé en ce que** la valeur moyenne de fréquence de la zone de filtrage du filtre passe-bande (6) à capacités commutées présente exactement la fréquence (14) prédéfinie par la minuterie (3) du microprocesseur (2).

17. Dispositif (1) selon l'une quelconque des revendications 15 à 16, **caractérisé en ce que** le signal (9) prélevé, perturbé éventuellement par la source de bruit (11) à large bande, est éliminé par un amplificateur (7) sur le filtre passe-bande (6).

18. Dispositif (1) selon l'une quelconque des revendications 15 à 17, **caractérisé en ce que** des condensateurs (8) sont disposés entre le réseau de distribution de tension continue (10) et le dispositif (1) pour détecter la source de bruit (11) à large bande.

19. Dispositif (1) selon l'une quelconque des revendications 15 à 18, **caractérisé en ce que** le signal de sortie (13) du filtre passe-bande (6) est éliminé par un redresseur (5) sur le microprocesseur (2).

20. Dispositif (1) selon la revendication 19, **caractérisé en ce que** le signal de sortie (13) du filtre passe-bande (6) est commuté sur une entrée analogique (4) du microprocesseur (2).

21. Dispositif (1) selon l'une quelconque des revendications 15 à 18, **caractérisé en ce que** le signal de sortie (13) du filtre passe-bande (6) est commuté directement sur le microprocesseur (2) et le microprocesseur (2) analyse lui-même la fraction variable du signal (13).

22. Dispositif selon l'une quelconque des revendications 15 à 21, **caractérisé en ce que** le microprocesseur (2) présente un processeur de signaux qui assume l'analyse du signal des valeurs d'amplitude mesurées par le filtre passe-bande (6).

23. Dispositif selon l'une quelconque des revendications 15 à 22, **caractérisé en ce que** l'unité d'analyse (21) prioritaire et le microprocesseur (2) sont reliés entre eux au plan fonctionnel au moyen d'un bus CAN (22) d'un véhicule.

24. Dispositif selon l'une quelconque des revendications 15 à 23, **caractérisé en ce que** le réseau de distribution de tension continue (10) est le réseau de bord à tension continue d'un véhicule.

25. Dispositif selon la revendication 24, **caractérisé en ce que** le microprocesseur (2) est un microprocesseur (2) présent dans tous les cas dans un réseau de bord d'un véhicule automobile ou similaire.
